# EUROPÄISCHE PATENTSCHRIFT

(11) **EP 4 034 898 B1**
(45) Veröffentlichungstag und Bekanntmachung des Hinweises auf die Patenterteilung: **27.11.2024**
(21) Anmeldenummer: 20789493.2
(22) Anmeldetag: 30.09.2020
(51) Int. Cl.: G01R 31/34

(54) **VORRICHTUNG ZUR ERFASSUNG EINES HOCHFREQUENTEN EREIGNISSIGNALS IN EINER ELEKTRISCHEN ROTIERENDEN MASCHINE**
DEVICE FOR DETECTING A HIGH-FREQUENCY EVENT SIGNAL IN AN ELECTRIC ROTATING MACHINE
DISPOSITIF DE DÉTECTION D'UN SIGNAL D'ÉVÉNEMENT HAUTE FRÉQUENCE DANS UNE MACHINE ROTATIVE ÉLECTRIQUE

(30) Priorität: 16.12.2019 EP 19216617
(43) Veröffentlichungstag der Anmeldung: 03.08.2022
(73) Patentinhaber: Innomotics GmbH, 90441 Nürnberg (DE)
(72) Erfinder: MEYER, Martin, 90425 Nürnberg (DE); SCHEIBNER, Dirk, 90473 Nürnberg (DE); SCHIMMER, Jürgen, 90473 Nürnberg (DE)
(74) Vertreter: Siemens Patent Attorneys
(86) Internationale Anmeldenummer: PCT/EP2020/077305
(87) Internationale Veröffentlichungsnummer: WO 2021/121700

(56) Entgegenhaltungen:
- EP-A1- 3 570 052
- EP-B1- 0 662 220
- DE-A1- 102005 027 670
- US-B1- 6 452 416

## Beschreibung

Die Erfindung betrifft eine Vorrichtung zur Erfassung eines hochfrequenten Ereignissignals in einer elektrischen rotierenden Maschine.

Ferner betrifft die Erfindung ein Verfahren zur Erfassung eines hochfrequenten Ereignissignals in einer elektrischen rotierenden Maschine.

Darüber hinaus betrifft die Erfindung eine Steuereinheit mit Mitteln zur Durchführung eines derartigen Verfahrens.

Des Weiteren betrifft die Erfindung ein Computerprogramm zur Durchführung eines derartigen Verfahrens bei Ablauf in einer Steuereinheit.

Überdies betrifft die Erfindung ein Computerprogrammprodukt mit einem Computerprogramm.

Zudem betrifft die Erfindung eine elektrische rotierende Maschine mit mindestens einer derartigen Vorrichtung zur Erfassung eines hochfrequenten Ereignissignals.

Eine derartige Vorrichtung wird beispielsweise in elektrischen rotierenden Hochspannungsmaschinen, insbesondere Hochspannungsmotoren und Hochspannungsgeneratoren, verwendet, welche mit einer Spannung von mindestens 1kV betreibbar sind.

Unter einem hochfrequenten Ereignissignal ist beispielsweise ein gepulstes Signal in einem Frequenzbereich von 100 kHz bis 100 MHz zu verstehen. Der Puls weist eine rechteckige, eine gaußförmige oder eine andere Pulsform auf. Derartige hochfrequente Ereignissignale entstehen beispielsweise bei Teilentladungen, die bei elektrischen rotierenden Maschinen häufig auftreten. Bei Teilentladungen handelt es sich um lokale Entladungen, welche beispielsweise durch Inhomogenitäten in einem Isolierstoff verursacht werden und unter Umständen langfristig zum Versagen der Isolierung und damit zu einem Ausfall der Hochspannungsmaschine führen. Deshalb werden elektrische rotierende Hochspannungsmaschinen regelmäßig auf Teilentladungen untersucht. Insbesondere bei einer deutlichen Veränderung der Häufigkeit von Teilentladung ist es erforderlich, die Ursache zu finden. Insbesondere in größeren elektrischen rotierenden Maschinen können Teilentladungen nur räumlich begrenzt erkannt werden. Es werden daher mehrere Sensoren ausgewertet, um eine möglichst lückenlose Überwachung zu erreichen.

Die Patentschrift EP 0 662 220 B1 beschreibt ein Verfahren zur Auskopplung eines hochfrequenten Ereignissignals aus einem hochfrequenten elektromagnetischen Feld in einer elektrischen Großmaschine mit einem, eine elektrische Wicklung tragenden, und mit zumindest einem Temperaturfühler bestückten Ständer. Das hochfrequente Ereignissignal ist von dem als Antenne benutzten Temperaturfühler abzunehmen. Auf diese Weise wird der apparative Aufwand zur Auskopplung des Ereignissignals geringgehalten, und bei Verwendung einer Vielzahl von Temperaturfühlern ist eine Ortung eines Schadens, wo das Ereignissignal verursacht wurde, möglich.

Die Offenlegungsschrift EP 3 570 052 A1 beschreibt ein Verfahren zur Messung eines gepulsten hochfrequenten Ereignissignals, insbesondere einer Teilentladung, in einer elektrischen rotierenden Maschine. Um im Vergleich zum Stand der Technik, eine einfache und kostengünstige Implementierung zu erreichen, wird vorgeschlagen, dass das Ereignissignal aus einem hochfrequenten elektromagnetischen Feld mit Hilfe eines Sensors während eines Betriebes der elektrischen rotierenden Maschine ausgekoppelt wird, wobei aus dem ausgekoppelten Ereignissignal mit Hilfe einer Hochfrequenz-Detektorschaltung ein pulsförmiges niederfrequentes Hüllkurvensignal ermittelt wird, wobei, wenn eine Amplitude des Hüllkurvensignals einen Schwellwert überschreitet, ein Ereignissignal erfasst wird.

Der Erfindung liegt die Aufgabe zugrunde, eine Vorrichtung zur Erfassung eines hochfrequenten Ereignissignals in einer elektrischen rotierenden Maschine anzugeben, welche, im Vergleich zum Stand der Technik, einfach und kostengünstig zu implementieren ist.

Die Aufgabe wird erfindungsgemäß durch eine Vorrichtung zur Erfassung eines hochfrequenten Ereignissignals in einer elektrischen rotierenden Maschine gelöst, wobei mindestens zwei Sensoren zur Erfassung eines niederfrequenten Sensorsignals in der elektrischen rotierenden Maschine angeordnet sind, wobei die mindestens zwei Sensoren jeweils eine Antenne zur Auskopplung des hochfrequenten Ereignissignals aus einem hochfrequenten elektromagnetischen Feld der elektrischen rotierenden Maschine umfassen, wobei die Sensoren über ein gemeinsames, insbesondere reaktives, Koppelelement mit einer gemeinsamen HF-Auswertevorrichtung verbunden sind, wobei das gemeinsame Koppelelement zur Übertragung des hochfrequenten Ereignissignals von zumindest einem der Sensoren an die gemeinsame HF-Auswertevorrichtung und zum Entkoppeln des niederfrequenten Sensorsignals ausgebildet ist, wobei das gemeinsame, insbesondere reaktive, Koppelelement einen Transformator aufweist, wobei der Transformator primärseitige Wicklungen und eine sekundärseitige Wicklung aufweist, wobei jedem der mindestens zwei Sensoren jeweils eine primärseitige Wicklung zugewiesen ist, wobei der HF-Auswertevorrichtung die sekundärseitige Wicklung zugewiesen ist und wobei die primärseitigen Wicklungen jeweils mit der sekundärseitigen Wicklung verkoppelt sind.

Des Weiteren wird die Aufgabe erfindungsgemäß durch ein Verfahren zur Erfassung eines hochfrequenten Ereignissignals in einer elektrischen rotierenden Maschine gelöst, wobei mindestens zwei Sensoren zur Erfassung eines niederfrequenten Sensorsignals in der elektrischen rotierenden Maschine angeordnet sind, wobei die mindestens zwei Sensoren jeweils eine Antenne zur Auskopplung des hochfrequenten Ereignissignals aus einem hochfrequenten elektromagnetischen Feld der elektrischen rotierenden Maschine umfassen, wobei die Sensoren über ein gemeinsames, insbesondere reaktives, Koppelelement mit einer gemeinsamen HF-Auswertevorrichtung verbunden sind, wobei das hochfrequente Ereignissignal von zumindest einem der Sensoren über das gemeinsame Koppelelement an die gemeinsame HF-Auswertevorrichtung übertragen und vom niederfrequenten Sensorsignal entkoppelt wird, wobei das gemeinsame, insbesondere reaktive, Koppelelement als Transformator ausgeführt wird, wobei der Transformator primärseitig Wicklungen und eine sekundärseitige Wicklung aufweist, wobei jedem der mindestens zwei Sensoren jeweils eine primärseitige Wicklung zugewiesen werden, wobei der HF-Auswertevorrichtung die sekundärseitige Wicklung zugewiesen wird und wobei die primärseitigen Wicklungen jeweils mit der sekundärseitigen Wicklung verkoppelt werden.

Ferner wird die Aufgabe erfindungsgemäß durch eine Steuereinheit mit Mitteln zur Durchführung eines derartigen Verfahrens gelöst.

Darüber hinaus wird die Aufgabe erfindungsgemäß durch ein Computerprogramm zur Durchführung eines derartigen Verfahrens bei Ablauf in einer Steuereinheit gelöst.

Überdies wird die Aufgabe erfindungsgemäß durch ein Computerprogrammprodukt mit einem Computerprogramm gelöst.

Zudem wird die Aufgabe erfindungsgemäß durch eine elektrische rotierende Maschine mit mindestens einer derartigen Vorrichtung zur Erfassung eines hochfrequenten Ereignissignals gelöst.

Die in Bezug auf die Vorrichtung nachstehend angeführten Vorteile und bevorzugten Ausgestaltungen lassen sich sinngemäß auf das Verfahren, die Steuereinheit, das Computerprogramm, das Computerprogrammprodukt und die elektrische rotierende Maschine übertragen.

Der Erfindung liegt die Überlegung zugrunde, ein hochfrequentes Ereignissignal, beispielsweise eine Teilentladung, während des Betriebes einer elektrischen rotierenden Maschine mit minimalem Hardware-Aufwand zu erfassen. Zur elektrischen rotierenden Maschine gehören auch mit der Maschine verbundene Komponenten wie Kabel, Transformatoren, Filter, usw., in welchen ein derartiges hochfrequentes Ereignissignal erfassbar ist. Da, insbesondere in elektrischen rotierenden Hochspannungsmaschinen, hochfrequente Ereignissignale nur räumlich begrenzt detektierbar sind, werden mindestens zwei Sensoren verwendet, die über ein gemeinsames, insbesondere reaktives, Koppelelement mit einer gemeinsamen HF-Auswertevorrichtung verbunden sind. Ein reaktives Koppelelement ist ein, insbesondere passives, elektronisches Bauelement, welches im Wesentlichen aus energiespeichernden Komponenten wie Spulen und Kondensatoren aufgebaut ist. Ein reaktives Bauelement ist daher sehr verlustarm. Auf diese Weise sind mehrere Sensoren über eine HF-Auswertevorrichtung auswertbar, was aufgrund des reduzierten Hardware-Aufwands zu einer Kostenreduktion führt. Ferner ist die Schaltung kleiner und einfacher.

Die Sensoren sind beispielsweise als kapazitive oder induktive Kopplungsvorrichtung, als Richtkoppler, als Temperaturfühler oder als ein anderer Sensor ausgestaltet. Da die Sensoren zur Erfassung eines niederfrequenten Sensorsignals in der elektrischen rotierenden Maschine bereits vorhanden sind, ist keine zusätzliche Sensorik erforderlich und es ist nicht erforderlich, die elektrische rotierende Maschine für die Erfassung des hochfrequenten Ereignissignals zu modifizieren. Ein niederfrequentes Sensorsignal ist beispielsweise ein Signal mit einer Frequenz von weniger als 1 kHz, während das hochfrequente Ereignissignal in einem Frequenzbereich von 100 kHz bis 100 MHz liegt. Die Auskopplung des hochfrequenten Ereignissignals aus einem hochfrequenten elektromagnetischen Feld der elektrischen rotierenden Maschine erfolgt mittels einer Antenne, wobei beispielsweise Zuleitungen der Sensoren als Antenne verwendet werden, wodurch keine zusätzlichen Modifikationen erforderlich sind. Das gemeinsame Koppelelement weist beispielsweise eine Bandpasscharakteristik oder eine Hochpasscharakteristik auf, sodass es, neben der Übertragung des hochfrequenten Ereignissignals von zumindest einem der Sensoren an die gemeinsame HF-Auswertevorrichtung, zur Entkopplung des niederfrequenten Sensorsignals ausgebildet ist.

Durch eine Steuereinheit wird der Verfahrensablauf gesteuert. Die Mittel zur Durchführung des Verfahrens umfassen ein Computerprogramm und beispielweise einen Mikrocontroller oder einen anderen programmierbaren Logikbaustein. Die Steuereinheit ist beispielsweise dem Mikrocontroller zugeordnet.

Das gemeinsame, insbesondere reaktive, Koppelelement weist einen Transformator auf. Ein Transformator bietet eine sehr gute Entkopplung zwischen den Sensoren und der HF-Auswertevorrichtung im Frequenzbereich des niederfrequenten Sensorsignals. Ferner weist ein Transformator geringe Verluste im Frequenzbereich des hochfrequenten Ereignissignals auf und ist sowohl kostengünstig als auch kompakt zu realisieren.

Der Transformator weist primärseitige Wicklungen und eine sekundärseitige Wicklung auf, wobei jedem der mindestens zwei Sensoren jeweils eine primärseitige Wicklung zugewiesen ist, wobei der HF-Auswertevorrichtung die sekundärseitige Wicklung zugewiesen ist und wobei die primärseitigen jeweils mit der sekundärseitigen Wicklung verkoppelt sind. Die Wicklungen weisen beispielsweise Leiter aus Kupfer auf, um, insbesondere ohmsche, Verluste zu minimieren.

Wird beispielsweise ein Teilentladungsimpuls von zumindest einem der Sensoren empfangen und an die jeweilige primärseitige Wicklung übertragen, wird in der sekundärseitigen Wicklung ein Impuls induziert, der von der HF-Auswertevorrichtung empfangen und weiterverarbeitet wird. Die übrigen primärseitigen Wicklungen sind relativ hochohmig belastet, sodass sie nur einen vernachlässigbaren Einfluss ausüben. Mit einer derartigen Beschaltung des Transformators wird eine sehr gute Entkopplung zwischen den Sensoren und der HF-Auswertevorrichtung im Frequenzbereich des niederfrequenten Sensorsignals erreicht. Ferner wird eine verlustarme Übertragung eines hochfrequenten Ereignissignals von jedem der Sensoren kostengünstig und kompakt ermöglicht.

Bei einer weiteren vorteilhaften Ausgestaltung weist der Transformator einen magnetischen Kern, insbesondere einen ringförmigen Ferritkern, auf. Ein derartiger magnetischer Kern wird beispielsweise aus einem weichmagnetischen Werkstoff mit hoher magnetischer Sättigungsflussdichte und hoher magnetischer Permeabilität hergestellt. Derartige weichmagnetische Werkstoffe sind beispielsweise Eisen, einige Stähle, Nickel-Eisen-Legierungen, Cobalt-Eisen-Legierungen oder Ferrite. Durch einen derartigen magnetischen Kern wird der magnetische Fluss verlustarm gebündelt und geführt. Ferner werden die Abmessungen des Transformators durch Erhöhung der Induktivität der Wicklungen verringert.

Besonders vorteilhaft sind die primärseitigen und sekundärseitigen Wicklungen miteinander verdrillt angeordnet, um eine möglichst gute Kopplung bei höheren Frequenzen, insbesondere im MHz-Bereich, zu erreichen.

In einer bevorzugten Ausführungsform sind die Sensoren jeweils mit einer NF-Auswertevorrichtung zur Auswertung des niederfrequenten Sensorsignals verbunden, wobei die NF-Auswertevorrichtung zum Entkoppeln des hochfrequenten Ereignissignals ausgebildet ist. Beispielsweise ist die Eingangsimpedanz der NF-Auswertevorrichtung kapazitiv, sodass diese für das niederfrequente Sensorsignal als hochohmig und für das hochfrequente Ereignissignal im Wesentlichen als Kurzschluss erscheint. Eine derartige Beschaltung ermöglicht eine zeitgleiche Auswertung des niederfrequenten Sensorsignals und des hochfrequenten Ereignissignals.

Besonders vorteilhaft ist zumindest einer der Sensoren als Temperaturfühler ausgebildet. Der Temperaturfühler umfasst beispielsweise einen temperaturabhängigen Widerstand, der insbesondere aus Platin hergestellt ist. Beispielsweise werden Zuleitungen des Temperaturfühlers als Antenne zum Auskoppeln des hochfrequenten Ereignissignals aus dem hochfrequenten elektromagnetischen Feld verwendet. Insbesondere ist ein derartiger Temperaturfühler bereits in der elektrischen rotierenden Maschine vorhanden. Da sich die niederfrequente Messung der Temperatur sowie die Erfassung der gepulsten hochfrequenten Ereignissignale aufgrund der unterschiedlichen Frequenzbereiche nicht merklich beeinflussen, ist ein derartiger Temperaturfühler als Sensor einfach, kostengünstig und platzsparend.

Bei einer weiteren vorteilhaften Ausgestaltung sind das niederfrequente Sensorsignal und das hochfrequente Ereignissignal differenzielle Signale. Derartige Signale weisen keinen Massebezug auf und sind daher weniger anfällig für, insbesondere elektromagnetische, Störungen aus dem Umfeld.

In einer weiteren vorteilhaften Ausführungsform sind die Sensoren dem gemeinsamen, insbesondere reaktiven, Koppelelement jeweils einzeln zuschaltbar. Die Sensoren sind beispielsweise über Schalter, welche insbesondere über eine Steuereinheit ansteuerbar sind, dem Koppelelement einzeln zuschaltbar, wodurch ein hochfrequentes Ereignissignal genauer lokalisierbar ist.

Im Folgenden wird die Erfindung anhand der in den Figuren dargestellten Ausführungsbeispiele näher beschrieben und erläutert.

Es zeigen:
- FIG 1: einen Längsschnitt einer elektrischen rotierenden Maschine mit einer Sensorvorrichtung und
- FIG 2: eine schematische Darstellung einer ersten Ausgestaltung einer Vorrichtung zur Erfassung eines hochfrequenten Ereignissignals in einer elektrischen rotierenden Maschine und
- FIG 3: eine schematische Darstellung einer zweiten Ausgestaltung einer Vorrichtung zur Erfassung eines hochfrequenten Ereignissignals in einer elektrischen rotierenden Maschine.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

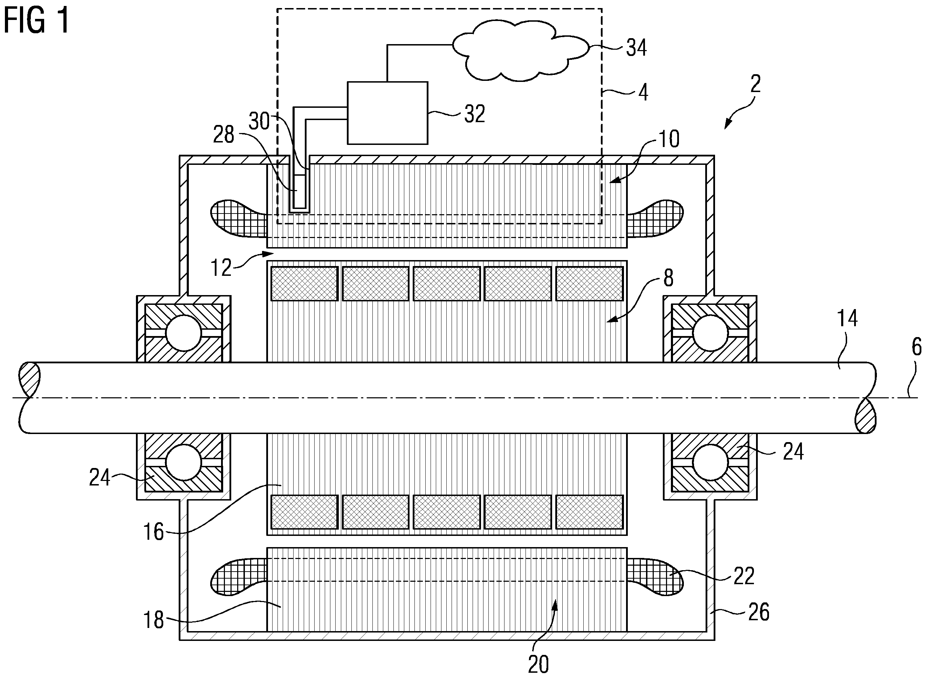

FIG 1 zeigt einen Längsschnitt einer elektrischen rotierenden Maschine 2 mit einer Vorrichtung 4 zur Erfassung eines hochfrequenten Ereignissignals. Die elektrische rotierende Maschine 2 ist exemplarisch als permanenterregte Synchronmaschine ausgeführt, wobei weitere Maschinentypen, wie beispielsweise Asynchronmaschinen, ebenfalls zum Gegenstand der Erfindung gehören.

Die elektrische rotierende Maschine 2 weist einen um eine Rotationsachse 6 rotierbaren Rotor 8 und einen den Rotor 8 umgebenden Stator 10 auf, wobei sich zwischen dem Rotor 8 und dem Stator 10 ein Spalt 12, der insbesondere als Luftspalt ausgeführt ist, befindet. Die Rotationsachse 6 definiert eine Axialrichtung, eine Umfangsrichtung und eine Radialrichtung. Der Rotor 8 umfasst eine Welle 14 und ein Rotorblechpaket 16. Der Stator 10 umfasst ein Statorblechpaket 18 mit Statorwicklungen 20, wobei das Statorblechpaket 18 aus einer Vielzahl von geschichteten Elektroblechen aufgebaut ist. Die Statorwicklungen 20 verlaufen in Axialrichtung durch das Statorblechpaket 18 und bilden an den axialen Enden des Statorblechpakets 18 Wickelköpfe 22 aus. Die Welle 14 des Rotors 8 ist über Lager 24 gelagert. Der Rotor 8 und der Stator 10 sind in einem geschlossenen Maschinengehäuse 26 untergebracht.

Die Vorrichtung 4 zur Erfassung eines hochfrequenten Ereignissignals umfasst Sensoren 28, die beispielsweise in einem Kanal 30, im Bereich der Statorwicklungen 20 angeordnet sind. Der Kanal 30 verläuft beispielhaft radial durch das Statorblechpaket 18. Alternativ ist der Kanal 30 in eine andere Richtung, beispielsweise in Umfangsrichtung oder in Axialrichtung, durch den Stator 10 oder durch den Rotor 8 verlaufend angeordnet. Die Anordnung der Sensorvorrichtung 4 ist aus Gründen der Übersichtlichkeit nur schematisch dargestellt, wobei insbesondere nur ein Sensor 28 in FIG 1 dargestellt ist. Die Sensoren 28 sind mit einer Auswertevorrichtung 32 verbunden, welche wiederum mit einer zentralen IT-Infrastruktur 34 verbunden ist. Eine zentrale IT-Infrastruktur 34 ist beispielsweise mindestens ein lokales Computersystem und/oder eine Cloud. Die zentrale IT-Infrastruktur 34 stellt Speicherplatz, Rechenleistung und/oder Anwendungssoftware bereit. In der Cloud werden Speicherplatz, Rechenleistung und/oder Anwendungssoftware als Dienstleistung über das Internet zur Verfügung gestellt. Die digitale Datenübertragung an die zentrale IT-Infrastruktur 34 findet drahtlos, drahtgebunden oder optisch statt. Beispielsweise werden die Daten über Bluetooth oder WLAN übertragen.

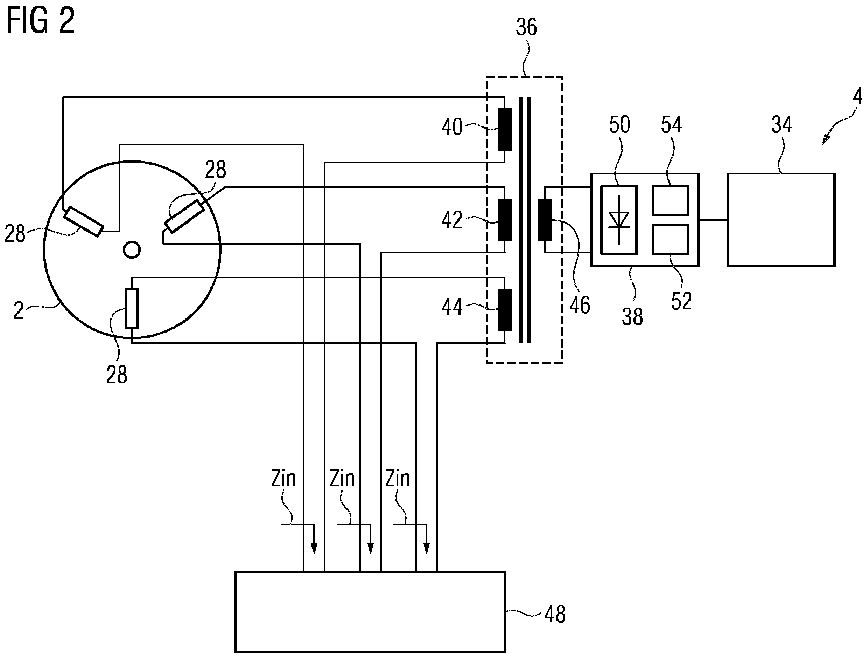

FIG 2 zeigt eine schematische Darstellung einer ersten Ausgestaltung einer Vorrichtung 4 zur Erfassung eines hochfrequenten Ereignissignals in einer elektrischen rotierenden Maschine 2, wobei die elektrische rotierende Maschine 2 sowie die Anordnung der Sensoren 28 in der elektrischen rotierenden Maschine 2 aus Gründen der Übersichtlichkeit stark abstrahiert dargestellt ist. Beispielhaft werden drei Sensoren 28 verwendet, wobei jeder der drei Phasen der elektrischen rotierenden Maschine 2 ein Sensor zugewiesen ist. Unter einem hochfrequenten Ereignissignal ist beispielsweise ein gepulstes Signal in einem Frequenzbereich von 100 kHz bis 100 MHz zu verstehen. Der Puls weist eine rechteckige, eine gaußförmige oder eine andere Pulsform auf. Das hochfrequente Ereignissignal wird mittels der Sensoren 28 aus einem hochfrequenten elektromagnetischen Feld während eines Betriebes der elektrischen rotierenden Maschine 2 ausgekoppelt. Das hochfrequente elektromagnetische Feld wird insbesondere von der elektrischen rotierenden Maschine 2 erzeugt.

Die Sensoren 28 sind exemplarisch als ein Temperaturfühler ausgestaltet, welcher jeweils einen temperaturabhängigen Widerstand, der beispielsweise aus Platin hergestellt ist, und Zuleitungen umfassen, wobei die Zuleitungen als Antenne zum Auskoppeln des hochfrequenten Ereignissignals verwendet werden. Die Sensoren 28 sind über ein gemeinsames, insbesondere reaktives, Koppelelement 36 mit einer gemeinsamen HF-Auswertevorrichtung 38 verbunden, wobei das gemeinsame Koppelelement 36 zur Übertragung des hochfrequenten Ereignissignals von zumindest einem der Sensoren 28 an die gemeinsame HF-Auswertevorrichtung 38 und zum Entkoppeln des niederfrequenten Sensorsignals ausgebildet ist. Das Koppelelement 36 weist einen Transformator auf, welcher primärseitige Wicklungen 40, 42, 44 und eine sekundärseitige Wicklung 46 aufweist. Die Wicklungen 40, 42, 44, 46 weisen beispielsweise Leiter aus Kupfer auf, um, insbesondere ohmsche, Verluste zu minimieren. Optional umfasst das gemeinsame, insbesondere reaktive, Koppelelement 36 zusätzliche Bauelemente, beispielsweise zur Leistungs- und/oder Impedanz-Anpassung, wie Spulen und/oder Kondensatoren. Jedem der Sensoren 28 ist eine primärseitige Wicklung 40, 42, 44 zugewiesen, wobei der HF-Auswertevorrichtung 38 die sekundärseitige Wicklung 46 zugewiesen ist. Die primärseitigen Wicklungen 40, 42, 44 sind zur Übertragung des hochfrequenten Ereignissignals jeweils mit der sekundärseitigen Wicklung 46 verkoppelt. Es ist exemplarisch ein Transformator mit drei primärseitigen Wicklungen 40, 42, 44 gezeigt. Alternativ weist der Transformator, je nach Anzahl der zu verbindenden Sensoren 28, zwei, vier oder mehr primärseitige Wicklungen 40, 42, 44 auf. Der Transformator weist einen magnetischen Kern, insbesondere einen ringförmigen Ferritkern, auf, wobei die primärseitigen und sekundärseitigen Wicklungen 40, 42, 44, 46 miteinander verdrillt und um den Ferritkern gewickelt angeordnet sind.

Zusätzlich sind die Sensoren 28 jeweils mit einer gemeinsamen NF-Auswertevorrichtung 48 zur Auswertung des niederfrequenten Sensorsignals verbunden, wobei jeder der Sensoren 28 mit einem Eingangskanal der NF-Auswertevorrichtung 48 verbunden ist. Alternativ ist jedem der Sensoren 28 eine dedizierte NF-Auswertevorrichtung 48 zugewiesen. Insbesondere sind das niederfrequente Sensorsignal und das hochfrequente Ereignissignal differenzielle Signale. Die primärseitigen Wicklungen 40, 42, 44 sind jeweils in Serie zur NF-Auswertevorrichtung 48 geschaltet, wobei über den Transformator, der eine Bandpasscharakteristik aufweist, das niederfrequente Sensorsignal entkoppelt wird und wobei über die Eingangsimpedanz Zin der NF-Auswertevorrichtung 48 das hochfrequente Ereignissignal entkoppelt wird. Insbesondere ist die Eingangsimpedanz Zin der NF-Auswertevorrichtung 48 kapazitiv, sodass diese für das niederfrequente Sensorsignal als hochohmig und für das hochfrequente Ereignissignal im Wesentlichen als Kurzschluss erscheint. Insbesondere sind die Leitungslängen zwischen der NF-Auswertevorrichtung 48 und dem Koppelelement 36 elektrisch kurz, damit der Kurzschluss nach der Leitungstransformation die Übertagung des HF-Signals zwischen den Sensoren 28 und dem Koppelelement 36 nicht merklich verschlechtert.

Wird beispielsweise ein Teilentladungsimpuls von zumindest einem der Sensoren 28 empfangen und an die jeweilige primärseitige Wicklung 40, 42, 44 übertragen, wird in der sekundärseitigen Wicklung 46 ein Impuls induziert, der von der HF-Auswertevorrichtung 38 empfangen und weiterverarbeitet wird. Die übrigen primärseitigen Wicklungen 40, 42, 44 sind, insbesondere durch den temperaturabhängigen Widerstand, relativ hochohmig belastet, sodass sie nur einen vernachlässigbaren Einfluss ausüben.

Die gemeinsame HF-Auswertevorrichtung 38 weist insbesondere eine Hochfrequenz-Detektorschaltung 50 zur Detektion des hochfrequenten Ereignissignals, einen Analog-DigitalUmsetzer 52 zur Digitalisierung des detektierten Signals und eine Steuereinheit 54 zur Steuerung des Verfahrensablaufs auf. Ferner ist die HF-Auswertevorrichtung 38 mit einer zentralen IT-Infrastruktur 34 verbunden. Die weitere Ausführung der Vorrichtung 4 in FIG 2 entspricht der Ausführung in FIG 1.

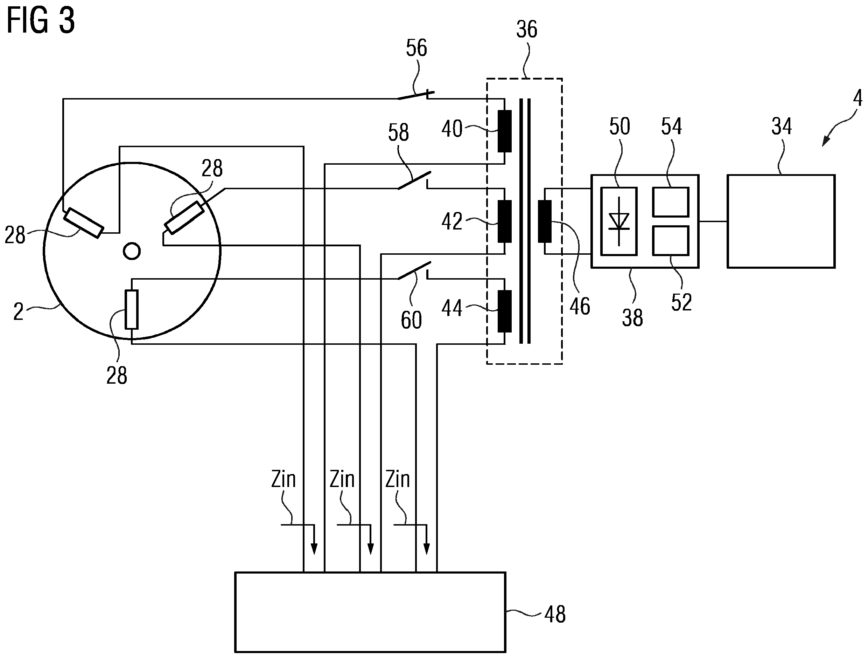

FIG 2 zeigt eine schematische Darstellung einer zweiten Ausgestaltung einer Vorrichtung 4 zur Erfassung eines hochfrequenten Ereignissignals in einer elektrischen rotierenden Maschine 2. Die Sensoren 28 sind über Schalter 56, 58, 60, welche beispielsweise über die Steuereinheit 54 ansteuerbar sind, den primärseitigen Wicklungen 40, 42, 44 des als Transformator ausgeführten gemeinsamen Koppelelements 36 einzeln zuschaltbar, wodurch ein hochfrequentes Ereignissignal genauer lokalisierbar ist. Die weitere Ausführung der Vorrichtung 4 in FIG 3 entspricht der Ausführung in FIG 2.

Zusammenfassend betrifft die Erfindung eine Vorrichtung 4 zur Erfassung eines hochfrequenten Ereignissignals in einer elektrischen rotierenden Maschine 2, wobei mindestens zwei Sensoren 28 zur Erfassung eines niederfrequenten Sensorsignals in der elektrischen rotierenden Maschine 2 angeordnet sind, wobei die mindestens zwei Sensoren 28 jeweils eine Antenne zur Auskopplung des hochfrequenten Ereignissignals aus einem hochfrequenten elektromagnetischen Feld der elektrischen rotierenden Maschine 2 umfassen. Um im Vergleich zum Stand der Technik, eine einfache und kostengünstige Implementierung zu erreichen, wird vorgeschlagen, dass die Sensoren 28 über ein gemeinsames, insbesondere reaktives, Koppelelement 36 mit einer gemeinsamen HF-Auswertevorrichtung 38 verbunden sind, wobei das gemeinsame Koppelelement 36 zur Übertragung des hochfrequenten Ereignissignals von zumindest einem der Sensoren 28 an die gemeinsame HF-Auswertevorrichtung 38 und zum Entkoppeln des niederfrequenten Sensorsignals ausgebildet ist.

## Patentansprüche

1. Vorrichtung (4) zur Erfassung eines hochfrequenten Ereignissignals in einer elektrischen rotierenden Maschine (2),
wobei mindestens zwei Sensoren (28) zur Erfassung eines niederfrequenten Sensorsignals in der elektrischen rotierenden Maschine (2) angeordnet sind,
wobei die mindestens zwei Sensoren (28) jeweils eine Antenne zur Auskopplung des hochfrequenten Ereignissignals aus einem hochfrequenten elektromagnetischen Feld der elektrischen rotierenden Maschine (2) umfassen,
wobei die Sensoren (28) über ein gemeinsames, insbesondere reaktives, Koppelelement (36) mit einer gemeinsamen HF-Auswertevorrichtung (38) verbunden sind,
wobei das gemeinsame Koppelelement (36) zur Übertragung des hochfrequenten Ereignissignals von zumindest einem der Sensoren (28) an die gemeinsame HF-Auswertevorrichtung (38) und zum Entkoppeln des niederfrequenten Sensorsignals ausgebildet ist,
wobei das gemeinsame, insbesondere reaktive, Koppelelement (36) einen Transformator aufweist,
**dadurch gekennzeichnet, dass**
der Transformator primärseitige Wicklungen (40, 42, 44) und eine sekundärseitige Wicklung (46) aufweist,
wobei jedem der mindestens zwei Sensoren (28) jeweils eine primärseitige Wicklung (40, 42, 44) zugewiesen ist,
wobei der HF-Auswertevorrichtung (38) die sekundärseitige Wicklung (46) zugewiesen ist und
wobei die primärseitigen Wicklungen (40, 42, 44) jeweils mit der sekundärseitigen Wicklung (46) verkoppelt sind.

2. Vorrichtung (4) nach Anspruch 1,
wobei der Transformator einen magnetischen Kern, insbesondere einen ringförmigen Ferritkern, aufweist.

3. Vorrichtung (4) nach einem der Ansprüche 1 oder 2,
wobei die primärseitigen und sekundärseitigen Wicklungen (40, 42, 44, 46) miteinander verdrillt angeordnet sind.

4. Vorrichtung (4) nach einem der vorherigen Ansprüche,
wobei die Sensoren (28) jeweils mit einer NF-Auswertevorrichtung (48) zur Auswertung des niederfrequenten Sensorsignals verbunden sind,
wobei die NF-Auswertevorrichtung (48) zum Entkoppeln des hochfrequenten Ereignissignals ausgebildet ist.

5. Vorrichtung (4) nach einem der vorherigen Ansprüche, wobei zumindest einer der Sensoren (28) als Temperaturfühler ausgebildet ist.

6. Vorrichtung (4) nach einem der vorherigen Ansprüche, wobei das niederfrequente Sensorsignal und das hochfrequente Ereignissignal differenzielle Signale sind.

7. Vorrichtung (4) nach einem der vorherigen Ansprüche, wobei die Sensoren (28) dem gemeinsamen, insbesondere reaktiven, Koppelelement (36) jeweils einzeln zuschaltbar sind.

8. Verfahren zur Erfassung eines hochfrequenten Ereignissignals in einer elektrischen rotierenden Maschine (2),
wobei mindestens zwei Sensoren (28) zur Erfassung eines niederfrequenten Sensorsignals in der elektrischen rotierenden Maschine (2) angeordnet sind,
wobei die mindestens zwei Sensoren (28) jeweils eine Antenne zur Auskopplung des hochfrequenten Ereignissignals aus einem hochfrequenten elektromagnetischen Feld der elektrischen rotierenden Maschine (2) umfassen,
wobei die Sensoren (28) über ein gemeinsames, insbesondere reaktives, Koppelelement (36) mit einer gemeinsamen HF-Auswertevorrichtung (38) verbunden sind,
wobei das hochfrequente Ereignissignal von zumindest einem der Sensoren (28) über das gemeinsame Koppelelement (36) an die gemeinsame HF-Auswertevorrichtung (38) übertragen und vom niederfrequenten Sensorsignal entkoppelt wird,
wobei das gemeinsame, insbesondere reaktive, Koppelelement (36) als Transformator ausgeführt wird,
**dadurch gekennzeichnet, dass**
der Transformator primärseitig Wicklungen (40, 42, 44) und eine sekundärseitige Wicklung (46) aufweist,
wobei jedem der mindestens zwei Sensoren (28) jeweils eine primärseitige Wicklung (40, 42, 44) zugewiesen werden,
wobei der HF-Auswertevorrichtung (38) die sekundärseitige Wicklung (46) zugewiesen wird und
wobei die primärseitigen Wicklungen (40, 42, 44) jeweils mit der sekundärseitigen Wicklung (46) verkoppelt werden.

9. Verfahren nach Anspruch 8,
wobei die primärseitigen und sekundärseitigen Wicklungen (40, 42, 44, 46) miteinander verdrillt werden.

10. Verfahren nach einem der Ansprüche 8 oder 9,
wobei die Sensoren (28) jeweils mit einer NF-Auswertevorrichtung (48) zur Auswertung des niederfrequenten Sensorsignals verbunden werden,
wobei die NF-Auswertevorrichtung (48) zum Entkoppeln des hochfrequenten Ereignissignals ausgebildet wird.

11. Verfahren nach einem der Ansprüche 8 bis 10,
wobei das niederfrequente Sensorsignal und das hochfrequente Ereignissignal differenziell übertragen werden.

12. Verfahren nach einem der Ansprüche 8 bis 11,
wobei die Sensoren (28) dem gemeinsamen, insbesondere reaktiven, Koppelelement (36) jeweils einzeln zugeschaltet werden.

13. Steuereinheit (54) mit Mitteln zur Durchführung eines Verfahrens nach einem der Ansprüche 8 bis 12.

14. Computerprogramm zur Durchführung eines Verfahrens nach einem der Ansprüche 8 bis 12 bei Ablauf in einer Steuereinheit (54) nach Anspruch 13.

15. Computerprogrammprodukt mit einem Computerprogramm nach Anspruch 14.

16. Elektrische rotierende Maschine (2) mit mindestens einer Vorrichtung (4) zur Erfassung eines hochfrequenten Ereignissignals nach einem der Ansprüche 1 bis 7.

## Claims

1. An apparatus (4) for sensing a high-frequency event signal in a rotating electrical machine (2),
wherein at least two sensors (28) for sensing a low-frequency sensor signal are arranged in the rotating electrical machine (2),
wherein the at least two sensors (28) each comprise an antenna for decoupling the high-frequency event signal from a high-frequency electromagnetic field of the rotating electrical machine (2),
wherein the sensors (28) are connected via a common, in particular reactive, coupling element (36) to a common HF evaluation apparatus (38),
wherein the common coupling element (36) is embodied for transferring the high-frequency event signal from at least one of the sensors (28) to the common HF evaluation apparatus (38) and for decoupling the low-frequency sensor signal,
wherein the common, in particular reactive, coupling element (36) has a transformer,
**characterised in that**
the transformer has primary-side windings (40, 42, 44) and a secondary-side winding (46),
wherein each of the at least two sensors (28) is allocated a primary-side winding (40, 42, 44) in each case,
wherein the HF-evaluation apparatus (38) is allocated to the secondary-side winding (46) and
wherein the primary-side windings (40, 42, 44) are each coupled to the secondary-side winding (46).

2. Apparatus (4) according to claim 1,
wherein the transformer has a magnetic core, in particular an annular ferrite core.

3. Apparatus (4) according to one of claims 1 or 2,
wherein the primary-side and secondary-side windings (40, 42, 44, 46) are arranged twisted with one another.

4. Apparatus (4) according to one of the preceding claims,
wherein the sensors (28) are each connected to an LF evaluation apparatus (48) for evaluation of the low-frequency sensor signal,
wherein the LF evaluation apparatus (48) is embodied to decouple the high-frequency event signal.

5. Apparatus (4) according to one of the preceding claims, wherein at least one of the sensors (28) is embodied as a temperature sensor.

6. Apparatus (4) according to one of the preceding claims, wherein the low-frequency sensor signal and the high-frequency event signal are differential signals.

7. Apparatus (4) according to one of the preceding claims, wherein the sensors (28) are able to be connected to the common, in particular reactive, coupling element (36) individually in each case.

8. Method for sensing a high-frequency event signal in a rotating electrical machine (2),
wherein at least two sensors (28) for sensing a low-frequency sensor signal are arranged in the rotating electrical machine (2),
wherein the at least two sensors (28) each comprise an antenna for decoupling the high-frequency event signal from a high-frequency electromagnetic field of the rotating electrical machine (2),
wherein the sensors (28) are connected via a common, in particular reactive, coupling element (36) to a common HF evaluation apparatus (38),
wherein the high-frequency event signal from at least one of the sensors (28) is transferred via the common coupling element (36) to the common HF evaluation apparatus (38) and decoupled from the low-frequency sensor signal, wherein the common, in particular reactive, coupling element (36) is designed as a transformer,
**characterised in that**
the transformer has primary-side windings (40, 42, 44) and a secondary-side winding (46),
wherein each of the at least two sensors (28) is allocated a primary-side winding (40, 42, 44) in each case,
wherein the secondary-side winding (46) is allocated to the HF-evaluation apparatus (38) and
wherein the primary-side windings (40, 42, 44) are coupled to the secondary-side winding (46) in each case.

9. Method according to claim 8,
wherein the primary-side and secondary-side windings (40, 42, 44, 46) are twisted together with one another.

10. Method according to one of claims 8 or 9,
wherein the sensors (28) are each connected to an LF evaluation apparatus (48) for evaluation of the low-frequency sensor signal,
wherein the LF evaluation apparatus (48) is embodied for decoupling the high-frequency event signal.

11. Method according to one of claims 8 to 10,
wherein the low-frequency sensor signal and the high-frequency event signal are transferred differentially.

12. Method according to one of claims 8 to 11,
wherein the sensors (28) are each connected individually to the common, in particular reactive, coupling element (36).

13. Control unit (54) with means for carrying out a method according to one of claims 8 to 12.

14. Computer program for carrying out a method according to one of claims 8 to 12 when executed in a control unit (54) according to claim 13.

15. Computer program product with a computer program according to claim 14.

16. Rotating electrical machine (2) with at least one apparatus (4) for sensing a high-frequency event signal according to one of claims 1 to 7.

## Revendications

1. Dispositif (4) de détection d'un signal d'évènement de haute fréquence dans une machine (2) électrique tournante, dans lequel au moins deux capteurs (28) de détection d'un signal de capteur de basse fréquence sont montés dans la machine (2) électrique tournante,
dans lequel les au moins deux capteurs (28) comprennent chacun une antenne de découplage du signal d'évènement de haute fréquence d'un champ électromagnétique de haute fréquence de la machine (2) électrique tournante,
dans lequel les capteurs (28) sont, par un élément (36) de couplage commun, en particulier réactif, reliés à un dispositif (38) commun d'évaluation HF,
dans lequel l'élément (36) de couplage commun est constitué pour la transmission du signal d'évènement de haute fréquence d'au moins l'un des capteurs (28) au dispositif (38) commun d'évaluation HF et pour le découplage du signal des capteurs de basse fréquence,
dans lequel l'élément (36) de couplage commun, en particulier réactif, comporte un transformateur,
**caractérisé en ce que**
le transformateur a des enroulements (40, 42, 44) du côté primaire et un enroulement (46) du côté secondaire,
dans lequel respectivement un enroulement (40, 42, 44) du côté primaire est affecté à chacun des au moins deux capteurs (28), dans lequel l'enroulement (46) du côté secondaire est affecté au dispositif (38) d'évaluation HF et
dans lequel les enroulements (40, 42, 44) du côté primaire sont couplés respectivement à l'enroulement (46) du côté secondaire.

2. Dispositif (4) suivant la revendication 1,
dans lequel le transformateur a un noyau magnétique, en particulier un noyau annulaire de ferrite.

3. Dispositif (4) suivant l'une des revendications 1 ou 2, dans lequel les enroulements (40, 42, 44, 46) du côté primaire et du côté secondaire sont torsadés entre eux.

4. Dispositif (4) suivant l'une des revendications précédentes,
dans lequel les capteurs (28) sont reliés respectivement à un dispositif (48) d'évaluation BF pour l'évaluation du signal de capteur de basse fréquence,
dans lequel le dispositif (48) d'évaluation BF est constitué pour le découplage du signal d'évènement de haute fréquence.

5. Dispositif (4) suivant l'une des revendications précédentes,
dans lequel au moins l'un des capteurs (28) est constitué sous la forme d'une sonde de température.

6. Dispositif (4) suivant l'une des revendications précédentes,
dans lequel le signal de capteur de basse fréquence et le signal d'évènement de haute fréquence sont des signaux différentiels.

7. Dispositif (4) suivant l'une des revendications précédentes,
dans lequel les capteurs (28) peuvent être connectés individuellement, respectivement à l'élément (36) de couplage commun, en particulier réactif.

8. Procédé de détection d'un signal d'évènement de haute fréquence dans une machine (2) électrique tournante,
dans lequel au moins deux capteurs (28) de détection d'un signal de capteur de basse fréquence sont montés dans la machine (2) électrique tournante,
dans lequel les au moins deux capteurs (28) comprennent chacun une antenne de découplage du signal d'évènement de haute fréquence d'un champ électromagnétique de haute fréquence de la machine (2) électrique tournante,
dans lequel les capteurs (28) sont, par un élément (36) de couplage commun, en particulier réactif, reliés à un dispositif (38) commun d'évaluation HF,
dans lequel le signal d'évènement de haute fréquence est transmis au dispositif (38) commun d'évaluation HF par au moins l'un des capteurs (28) en passant par l'élément (36) de couplage commun et est découplé du signal de capteur de basse fréquence,
dans lequel l'élément (36) de couplage commun, en particulier réactif, est réalisé sous la forme d'un transformateur,
**caractérisé en ce que**
le transformateur a des enroulements (40, 42, 44) du côté primaire et un enroulement (46) du côté secondaire,
dans lequel on affecte respectivement un enroulement (40, 42, 44) du côté primaire à chacun des au moins deux capteurs (28),
dans lequel on affecte l'enroulement (46) du côté secondaire au dispositif (38) d'évaluation HF et
dans lequel on couple les enroulements (40, 42, 44) du côté primaire respectivement à l'enroulement (46) du côté secondaire.

9. Procédé suivant la revendication 8,
dans lequel on torsade entre eux des enroulements (40, 42, 44, 46) du côté primaire et du côté secondaire.

10. Procédé suivant l'une des revendications 8 ou 9,
dans lequel on relie les capteurs (28) respectivement à un dispositif (48) d'évaluation BF pour l'évaluation du signal de capteur de basse fréquence,
dans lequel on constitue le dispositif (48) d'évaluation BF pour le découplage du signal d'évènement de haute fréquence.

11. Procédé suivant l'une des revendications 8 à 10,
dans lequel on transmet différentiellement le signal de capteur de basse fréquence et le signal d'évènement de haute fréquence.

12. Procédé suivant l'une des revendications 8 à 11,
dans lequel on connecte respectivement individuellement les capteurs (28) à l'élément (36) de couplage commun, en particulier réactif.

13. Unité (54) de commande comprenant des moyens pour effectuer un procédé suivant l'une des revendications 8 à 12.

14. Programme d'ordinateur pour effectuer un procédé suivant l'une des revendications 8 à 12, lors du déroulement dans une unité (54) de commande suivant la revendication 13.

15. Produit de programme d'ordinateur ayant un programme d'ordinateur suivant la revendication 14.

16. Machine (2) électrique tournante ayant au moins un dispositif (4) de détection d'un signal d'évènement de haute fréquence suivant l'une des revendications 1 à 7.
